# EUROPEAN PATENT SPECIFICATION

(11) **EP 0 239 669 B1**
(45) Date of publication and mention of the grant of the patent: **03.03.1993**
(21) Application number: 86116311.1
(22) Date of filing: 25.11.1986
(51) Int. Cl.: G03F 7/26

(54) **Method and apparatus of treating photoresists**
Verfahren und Vorrichtung für Photolackverarbeitung
Méthode et appareil pour le traitement des photoréserves

(30) Priority: 31.03.1986 JP 71080/86
(43) Date of publication of application: 07.10.1987
(73) Proprietor: USHIO DENKI KABUSHIKI KAISHA, Tokyo, 100 (JP)
(72) Inventor: Suzuki, Shinji, Yokohama-shi Kanagawa (JP); Arai, Tetsuji, Yokohama-shi Kanagawa (JP); Ohno, Kuniharu, Yokohama-shi Kanagawa (JP); Ueki, Kazuyoshi, Yokohama-shi Kanagawa (JP); Mimura, Yoshiki, Yokohama-shi Kanagawa (JP); Tanaka, Kazuya, Yokohama-shi Kanagawa (JP); Sugioka, Shinji, Yokohama-shi Kanagawa (JP); Suzuki, Hiroko, Yokohama-shi Kanagawa (JP)
(74) Representative: Betten, Jürgen, Dipl.-Ing.

(56) References cited:
- GB-A- 2 143 961
- SOLID STATE TECHNOLOGY, vol. 27, no. 7, July 1984, pages 45-46, Washington, New York, US; "Photoresist stabilization system"
- JOURNAL OF THE ELECTROCHEMICAL SOCIETY, vol. 29, no. 6, June 1982, pages 1379-1381, Princeton, New Yersey, US; R. ALLEN et al.: "Deep U.V. hardening of positive photoresist patterns"
- MICROELECTRONIC ENGINEERING, vol. 3, no. 1/4, December 1985, pages 329-337, Amsterdam, NL; A. GUTMANN et al.: "Thermal stability and etching resistance of formaldehyde- and deep UV-hardened photoresists"
- IBM TECHNICAL DISCLOSURE BULLETIN, vol. 26, no. 2, July 1983, pages 656-657, New York, US; F. MARTINET: "Control of resist-hardening process in a barrel plasma etcher system"

## Description

This invention relates to a method and an apparatus of treating photoresist materials applied on semi conductor wafer and, more particularly, to a method and an apparatus of treating the photoresist materials employing ultraviolet irradiation.

As for the prior-art treatment of a photoresist employing ultraviolet irradiation, exposing the photoresist to ultraviolet radiation is utilized in a treatment in which a mask pattern is formed by exposing the photoresist applied on a semiconductor wafer, in a preliminary cleansing treatment in which organic pollutants sticking on the surface of the semiconductor wafers are dissolved and cleansed away, etc., and recently attention has been paid to the application of this method to particular treatments of photoresists such as baking photoresist materials.

The baking process is an intermediate between a process of forming a photoresist pattern by applying, exposing and developing the photoresist and a process of executing ion implantation, plasma etching, etc. by using the photoresist pattern, and it is a heating process executed for improving the adhesiveness of the photoresist to a semiconductor substrate, heat resistance,etc. Studies have been made recently on a method in which ultraviolet rays are applied to the photoresist before or during the baking process after development so as to enhance the heat resistance and plasma resistance of the photoresist through the baking process in a shorter time.

When a light having a high ultraviolet intensity, such as a radiant light from a microwave-excited electrodeless discharge lamp having a high ultraviolet radiation efficiency, is applied to the photoresist to expedite the treatment, however, a gas is generated from the photoresist, and this gas causes the formation of bubbles, deformation of a photoresist pattern and deformation of a photoresist film, such as exfoliation, rupture or roughening thereof, thus causing imperfections of a semiconductor element.

It can be supposed that the generation of this gas is caused by a rapid photochemical reaction of the light sensitive radicals of the photoresist, by the photochemical reaction of HMDS (hexamethyldisilazine), which is applied to a wafer as a preliminary treatment for the application of the photoresist, or an antireflection coating, etc. on the photoresist, by the photochemical reaction of an additive to the photoresist such as dyestuff, by the photochemical reaction of a solvent remaining in the photoresist,etc.

These photochemical reactions are advanced remarkably by a light having a wavelength 300nm to 500nm, and more particularly, by a light having a wavelength in the spectral response region of the photoresist. Accordingly, when a microwave-excited electrodeless discharge lamp radiating a light including these wavelength areas is employed,the intensity of light cannot be enhanced. In other words, this apparatus has a problem that it cannot perform a high-speed treatment.

An object of this invention is to provide a method and an apparatus enabling the high-speed and effective treatment of the photoresist employing ultraviolet irradiation by preventing the deformation of the photoresist which is caused by the light radiated from the microwave-excited electrodeless discharge lamp.

Ultraviolet rays are applied to the photoresist, using a means to intercept or reduce selectively all or part of the wavelengths in the spectral response region of the photoresist out of radiant lights obtained from the microwave-excited electrodeless discharge lamp.

In this way, the photochemical reactions causing the generation of the gas from the photoresist are curbed and thus the deformation of the photoresist is prevented, even when the microwave-excited electrodeless discharge lamp radiating strongly the light in the wavelength area exerting destructive actions on the photoresist together with ultraviolet rays being effective for improving the heat resistance and plasma-etching resistance of the phtoresist is employed, since the light in the wavelength area exerting said destructive actions is not applied onto the photoresist, or since the intensity of this light is sufficiently weak, even if it is applied.

Moreover, the light applied to the photoresist still contains a strong ultraviolet component being effective for improving the heat resistance and plasma-etching resistance of the photoresist even when the wavelengths in the spectral response region of the photoresist are intercepted or reduced.

Accordingly,a method enabling the high-speed and effective treatment of the photoresist is accomplished.

Other objects and advantages of this invention will become apparent from the following description of the preferred form of the invention which is illustrated in the drawings accompanying and forming part of this specification.

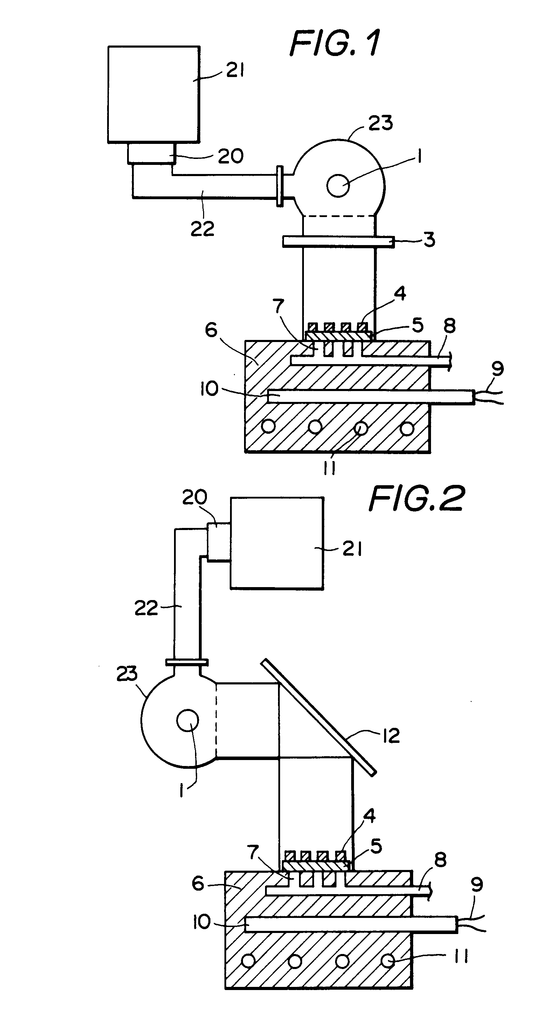

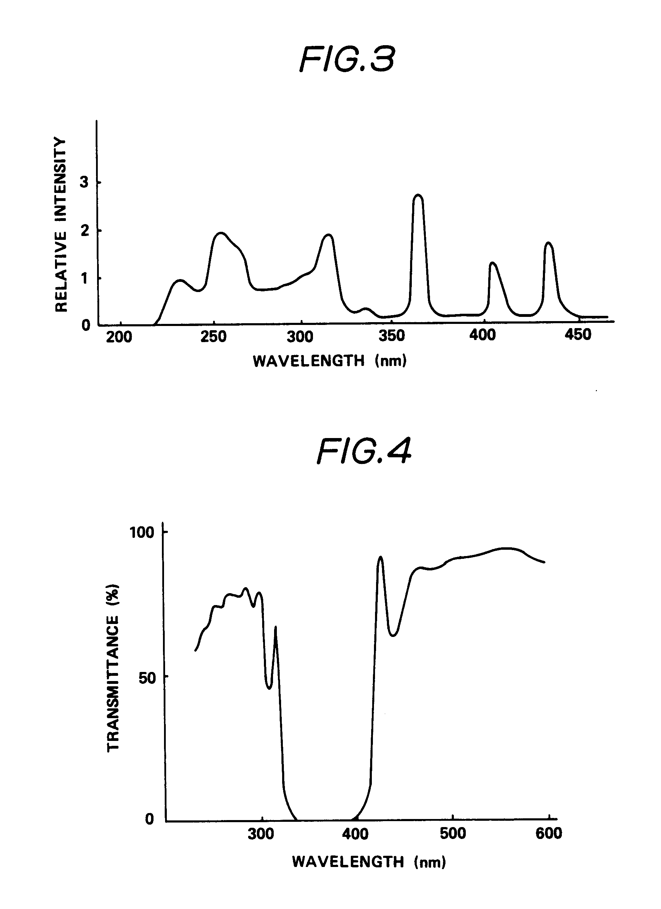

Fig. 1 shows an apparatus of treating a photoresist for explaining one embodiment of a method of treating a photoresist according to this invention. Fig. 2 shows another apparatus of treating a photoresist for explaining another embodiment. Fig. 3 shows one example of the radiation spectrum of the electrodeless discharge lamp employed in this invention. Fig.4 shows one example of the spectral transmittance characteristics of the filter employed in this invention.

This invention will be described concretely hereinafter on the basis of embodiments shown in drawings.

Figure 1 shows an embodiment of an apparatus of treating a photoresist for explaining one embodiment of a method for treatments of photoresists according to this invention.

A pattern of a photoresist 4 is formed on a semiconductor wafer 5, which is placed on a support 6. The support 6 is heated by a heater 10 connected with power supply through a heater lead wire 9,or cooled down by cooling water to flow through a cooling conduit 11. The temperature of the semi-conductor wafer 5 is controlled by these heating and cooling mechanisms. Moreover, the support 6 is provided with vacuum adsorption holes 7, a function of which is to fix the semi-conductor wafer 5 on the support 6 in close contact with it by the vacuum adsorption connected with a vacuum pump through a connecting conduit 8. A part of ultraviolet irradiation is composed of an electrodeless discharge lamp 1, a magnetron 20, a power supply 21, a wave guide 22, a cavity resonator 23 with a light-reflecting mirror, not shown in the figure, disposed inside, a filter 3, etc.

The magnetron 20 supplied with a power from the power supply 21 oscillates a microwave having a frequency of 2450 MHz. The microwave thus generated is guided in the cavity resonator 23 and forms a strong microwave magnetic field in the cavity resonator 23. By this strong microwave magnetic field the gas in the electrodeless discharge lamp 1 is excited, so as to radiate a light containing ultraviolet lights.

As for a gas filled in the electrodeless discharge lamp 1, a rare gas such as an argon gas is used, and it is known that an addition of a small quantity of mercury thereto effects the radiation of strong ultraviolet rays. An electrodeless discharge lamp radiating strongly a light having a wavelength of 220 nm to 230 nm is disclosed in Japanese Unexamined Patent Publication ("KOKAI KOHO") in Japan) 59- 877 51 ( U.S.Application No. 433,069 ), and this lamp may be used well,but the wavelength area of ultraviolet rays which is effective for improving the heat resistance and plasma- etching resistance of a photoresist is so wide as 220 nm to 300 nm, and therefore an electrodeless discharge lamp radiating a strong light in this area is preferable. In this regard, a suitable electrodeless discharge lamp radiating a strong light in the area of 220 nm to 300 nm is attained by adding more mercury than disclosed in the aforesaid Japanese Unexamined Patent Publication.

The radiant light from the electrodeless discharge lamp 1 is passed through the filter 3 etc, and applied to the photoresist 4. Figure 3 shows one example of the radiation spectrum of the electrodeless discharge lamp 1 employed in this embodiment. As for the filter 3, a filter intercepting or reducing a light in the wavelength area of 300 nm to 500 nm, that is, a wavelength area including the wavelengths in the spectral response region of the photoresist, is employed herein,and thereby the treatment of the photoresist employing ultraviolet irradiation can be performed effectively.

It is suitable to employ a filter prepared by forming a multilayer evaporation film on a glass plate, for obtaining the characteristic of intercepting or reducing the light in the wavelength area of 300 nm to 500 nm. The glass plate preferable for this filter is of the silica glass showing a large transmittance of ultraviolet rays of a wavelength 300 nm or below which are effective for the improvement in the heat resistance and plasma-etching resistance of the photoresist.

By using this apparatus, the radiant light from the electrodeless discharge lamp is applied to a sample which was prepared by using HPR-1182,OFPR-800, OFPR-5000 and TSMR-8800 as the photoresist, and HMDS as an agent which is applied to a wafer as a preliminary treatment for the application of the photoresist. While deformation took place in any samples of photoresists when the aforesaid filter was not employed, no deformation of the photoresist occurred and the heat resistance and plasma-etching resistance of the photoresist were improved when this filter was employed so as to intercept the light of 300 nm to 500 nm.

An electrodeless discharge lamp which contains a filling comprised of mercury and argon gas radiates strongly the lights of 312 nm, 365 nm, 405 nm and 436 nm. When this lamp and a narrow-band filter intercepting these lights are employed, deformation of the photoresist does not occur either.

Figure 2 shows another embodiment in which a mirror is employed as a means to intercept or reduce the radiant light in wavelength area of 300 nm to 500 nm. The mirror 12 employed herein has a characteristic of reflecting a radiant light in a wavelength area below 300 nm and not reflecting the radiant light of 300 nm to 500 nm. A mirror formed by evaporation of a multilayer film is suitable also for the mirror having the above-mentioned characteristic. The same effect as in the apparatus illustrated in figure 1, in which the filter is employed, can be attained also in the apparatus illustrated in figure 2, in which the mirror having the said characteristic is employed. When a conventional mirror reflecting the whole of the radiant light from the electrodeless discharge lamp is employed in place of the mirror having the aforesaid characteristic, deformation took place in the aforesaid samples of the photoresist.

In the above-mentioned embodiment, the electrodeless discharge lamp which containes the filling comprised of mercury and an argon gas is used to enable the radiation of ultraviolet lights of high intensity. The gas usable to this lamp is not limited thereto. A filling comprised of gas and a very small quantity of metal other than mercury in the form of a halide, for instance, may be used as well on condition that the electrodeless discharge lamp containing the filling radiates ultraviolet rays of a prescribed wave-length, and further a filling comprised of mercury and a rare gas other than argon, mixed gas which consists of rare gases other than a rgon, may also be employed.

As for the frequency of a microwave, it is not limited to 2450 MHz, and a microwave having another frequency may be used on condition that it can excite the gas enclosed in the lamp efficiently. Morever, a high frequency whose wavelength is longer than the microwave may be used as well.

In addition to the above-described embodiments, the filter or the mirror is employed separately as a means to intercept or reduce the light having the wavelengths in the spectral response region of the photoresist. It is a matter of course that a combination of filters and mirrors may be employed.

## Claims

1. A method of treating a photoresist which is applied in order to enhance the thermal stability of the photoresist film on a semiconductor wafer and exposed to radiant lights including ultraviolet rays, comprising the step of:
obtaining radiant lights from a microwave excited electrodeless discharge lamp;
characterized by the steps of:
intercepting or reducing selectively all or part of the light in the range of wavelengths 300 - 500 nm which generate gas bubble in the photoresists in the spectral response region of the photoresist out of the radiant lights;
and exposing the photoresist to the lights obtained in said step.

2. An apparatus of treating a photoresist (4) which is applied on a semiconductor wafer (5) and exposed to radiant lights including ultraviolet rays, comprising
a microwave excited electrodeless discharge lamp (1);
characterized by means (3;12) to intercept or reduce selectively all or part of the light in the range of wavelengths 300 - 500 nm which generate gas bubble in the photoresists in the spectral response region of the photoresist out of the radiant lights.

3. The apparatus according to claim 2, wherein said means is comprised of a filter (3).

4. The apparatus according to claim 3, wherein said filter (3) is comprised of a filter prepared by forming a multilayer evaporation film on a glass plate.

5. The apparatus according to claim 4, wherein said glass plate is comprised of silica glass.

6. The apparatus according to claim 2, wherein said means is comprised of a mirror (12).

7. The apparatus according to claim 6, wherein said mirror is comprised of a mirror formed by evaporation of a multilayer film on a plate.

8. The apparatus according to claim 2, wherein said means is comprised of a combination of a filter and a mirror.

9. The apparatus according to claim 2, wherein said lamp (1) contains a filling comprised of mercury and an argon gas.

10. The apparatus according to claim 2, wherein said lamp (1) contains a filling comprised of a gas and a very small quantity of metal other than mercury in the form of a halide.

## Patentansprüche

1. Verfahren zum Behandeln eines Fotolacks, der aufgebracht ist, um die thermische Stabilität des Fotolackfilms auf einem Halbleiter-Wafer zu erhöhen und Strahlungslicht einschließlich Ultraviolettstrahlen ausgesetzt wird, welches die Schritte umfaßt:
Strahlungslicht von einer Mikrowellen-erregten elektrodenlosen Entladungslampe erhalten,
gekennzeichnet durch die Schritte:
Selektiv alles oder einen Teil des Lichts im Bereich der Wellenlängen 300 bis 500 nm aus dem Strahlungslicht abzufangen oder zu reduzieren, welches in den Fotolacken im spektralen Ansprechbereich des Fotolackes Gasblasen erzeugt,
und den Fotolack dem im genannten Schritt erhaltenen Licht aussetzen.

2. Vorrichtung zum Behandeln eines Fotolacks (4), der auf einem Halbleiter-Wafer (5) aufgebracht wird und Strahlungslicht einschließlich Ultraviolettstrahlen ausgesetzt wird, mit
einer Mikrowellen-erregten elektrodenlosen Entladungslampe (1),
gekennzeichnet durch eine Einrichtung (3; 12), um selektiv alles oder einen Teil des Lichts im Bereich der Wellenlängen 300 bis 500 nm aus dem Strahlungslicht abzufangen, welches in den Fotolacken im spektralen Ansprechbereich des Fotolackes Gasblasen erzeugt.

3. Vorrichtung nach Anspruch 2, wobei die Einrichtung von einem Filter (3) gebildet ist.

4. Vorrichtung nach Anspruch 3, wobei der Filter (3) aus einem Filter besteht, der durch Ausbildung eines Vielschicht-Verdampfungsfilmes auf einer Glasplatte hergestellt wurde.

5. Vorrichtung nach Anspruch 4, wobei die Glasplatte aus Silika-Glas besteht.

6. Vorrichtung nach Anspruch 2, wobei die Einrichtung von einem Spiegel (12) gebildet ist.

7. Vorrichtung nach Anspruch 6, wobei der Spiegel ein Spiegel ist, der durch Aufdampfen eines Vielschicht-Filmes auf einer Platte gebildet ist.

8. Vorrichtung nach Anspruch 2, wobei die Einrichtung von einer Kombination eines Filters und eines Spiegels gebildet ist.

9. Vorrichtung nach Anspruch 2, wobei die Lampe (1) eine Füllung mit Quecksilber und einem Argon-Gas umfaßt.

10. Vorrichtung nach Anspruch 2, wobei die Lampe (1) eine Füllung aus einem Gas und einer sehr kleinen Menge eines anderen Metalls als Quecksilber in Form eines Halogenids enthält.

## Revendications

1. Un procédé de traitement d'une photoréserve qui est appliquée de manière à augmenter la stabilité thermique du film de photoréserve sur une pastille semi-conductrice et qui est exposée à des lumières radiantes, y compris des rayons ultraviolets, comprenant l'opération consistant à :
obtenir des lumières radiantes à partir d'une lampe à décharges sans électrode à excitation par micro-ondes ;
caractérisé par les opérations consistant à :
intercepter ou réduire de manière sélective tout ou partie de la lumière dans la gamme des longueurs d'onde de 300 à 500 nm qui engendrent un bouillonnement gazeux dans les photoréserves dans les zones de réponse spectrale de la photoréserve hors des lumières radiantes ;
et exposer la photoréserve aux lumières obtenues dans ladite opération.

2. Un appareil de traitement d'une photoréserve (4) qui est appliquée sur une pastille semi-conductrice (5) et qui est exposée à des lumières radiantes, y compris des rayons ultraviolets, comprenant
une lampe à décharge (1) sans électrode à excitation par micro-ondes ;
caractérisé par des moyens (3 ; 12) pour intercepter ou réduire de manière sélective tout ou partie de la lumière dans la gamme des longueurs d'onde de 300 à 500 nm qui engendrent un bouillonnement gazeux dans les photoréserves dans la zone de réponse spectrale de la photoréserve hors des lumières radiantes.

3. L'appareil selon la revendication 2, dans lequel lesdits moyens sont composés d'un filtre (3).

4. L'appareil selon la revendication 3, dans lequel ledit filtre (3) est composé d'un filtre préparé en formant une pellicule d évaporation multi-couche sur une plaque de verre.

5. L'appareil selon la revendication 4, dans lequel ladite plaque de verre est composée de verre de silice.

6. L'appareil selon la revendication 2, dans lequel lesdits moyens sont composés d'un miroir (12).

7. L'appareil selon la revendication 6, dans lequel ledit miroir est composé d'un miroir formé par évaporation d'une pellicule multi-couche sur une plaque.

8. L'appareil selon la revendication 2, dans lequel lesdits moyens sont composés de la combinaison d'un filtre et d'un miroir.

9. L'appareil selon la revendication 2, dans lequel ladite lampe (1) contient un remplissage composé de mercure et d'un gaz à base d'argon.

10. L'appareil selon la revendication 2, dans lequel ladite lampe (1) contient un remplissage composé d'un gaz et d'une très petite quantité de métal autre que le mercure sous la forme d'un halogénure.
